# EUROPEAN PATENT APPLICATION

(11) **EP 1 758 247 A2**
(43) Date of publication of application: **28.02.2007**
(21) Application number: 06254411.9
(22) Date of filing: 23.08.2006
(51) Int. Cl.: H03H 9/70, H03H 9/72

(54) **Duplexer having matching circuit**

(30) Priority: 25.08.2005 JP 2005244643
(71) Applicant: Fujitsu Media Devices Limited, Yokohama-shi, Kanagawa 222-0033 (JP); Fujitsu Ltd., Kawasaki-shi, Kanagawa 211-8588 (JP)
(72) Inventor: Tsutsumi, Jun, c/o Fujitsu Limited, Kawasaki-shi Kanagawa 211-8588 (JP); Iwaki, Masafumi, c/o Fujitsu Limited, Kawasaki-shi Kanagawa 211-8588 (JP); Iwamoto, Yasuhide, c/o Fujitsu Limited, Kawasaki-shi Kanagawa 211-8588 (JP); Ueda, Masanori, c/o Fujitsu Media Devices Limited, Yokohama-shi Kanagawa 222-0033 (JP)
(74) Representative: Hitching, Peter Matthew

(57) **Abstract**

A duplexer (50) includes a first filter (10) connected to a common terminal, a second filter (20) connected to the common terminal (Ant), an additional inductor (L10,L20) connected between at least one of the first and second filters and ground, a matching-use inductor (L30) connected between the common terminal and the ground, and a capacitor (C2) connected between the common terminal and at least one of the first and second filters.

## Description

### BACKGROUND OF THE INVENTION

### 1. Field of the invention

The present invention generally relates to duplexers, and more particularly, to a duplexer having a matching circuit.

### 2. Description of the Related Art

Recently, portable telephone devices or portable information terminal equipments have been widely popularized due to expanding development of mobile communications systems. For example, the portable telephone devices use a high-frequency band such as a 800MHz - 1.0GHz band or a 1.5GHz to 2.0GHz band. Devices for mobile communications systems are equipped with a duplexer having resonators. Generally, the duplexer is required to have a reduced size, a reduced insertion loss and a high out-of-band characteristic.

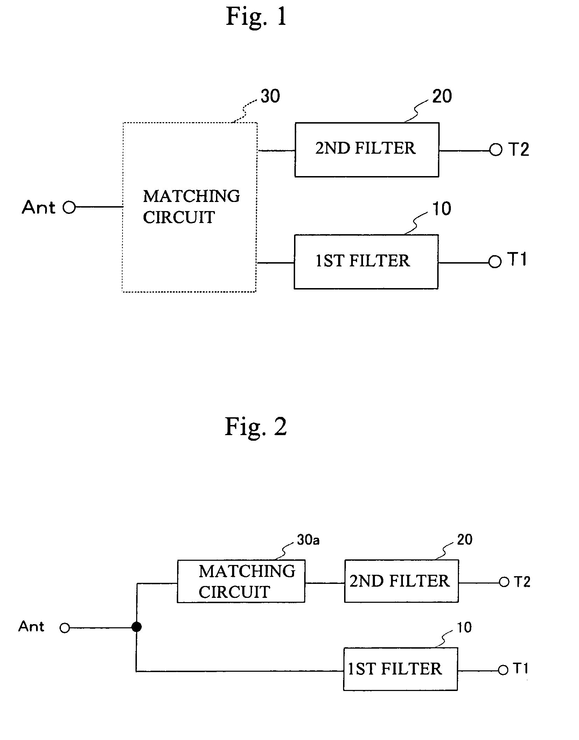

A duplexer will now be described with reference to Fig. 1. The duplexer uses two band-pass filters, namely, a first filter 10 and a second filter 20. The first filter 10 is provided between a first terminal T1 and a common terminal Ant, and the second filter is provided between a second terminal T2 and the common terminal Ant. A matching circuit 30 may be provided between the common terminal Ant and the first filter 10 or the second filter 20. The second filter 20 has a pass band of frequencies higher than those of the pass band of the first filter 10. In the portable telephone devices, the first filter 10 may be a transmit filter having a pass band for transmission and the second filter may be a receive filter having a pass band for reception. The common terminal Ant may be an antenna terminal to which an antenna is connected. The following description assumes that the first and second filters 10 and 20 are respectively transmit and receive filters.

A transmitted signal is applied to a first terminal T1 (transmit terminal) and passes through the first filter 10. Then, the filtered signal is output via the common terminal Ant. A received signal is applied to the second filter 20 via the common terminal Ant, and the filtered signal is output via a second terminal (receive terminal) T2. The duplexer is required to have characteristics of reduced insertion loss in passage of the transmitted signal from the first terminal T1 to the common terminal Ant and a sufficient attenuation of the first filter 10 in the receive range (that is the pass band of the second filter 20), namely, a high out-of-band characteristic.

The matching circuit 30 functions to prevent the transmitted signal from the first terminal T1 from entering into the second filter 20 and to cause the transmitted signal to be reliably output via the common terminal Ant. Generally, in the transmit range, the impedance viewed from the common terminal Ant to the second filter 20 is not infinite, and part of the transmitted signal invades the second filter 20. The matching circuit 30 converts the impedance viewed from the common terminal Ant to the second filter 20 in the transmit range into approximately infinite impedance. It is thus possible to prevent the transmitted signal from entering into the second filter 20. Similarly, the matching circuit 30 may be designed to prevent the power of received signal from being applied to the first filter 10 to thus improve the insertion loss of the second filter 20.

Various matching circuits specifically designed to downsize the duplexer and improve the insertion loss thereof have been developed. Fig. 2 shows a duplexer (first prior art) shown in Japanese Patent No. 3246906 (Document 1) in which a matching circuit 30a formed by a phase shifter is provided between the common terminal Ant and the second filter 20. Fig. 3 shows another duplexer (second prior art) shown in Japanese Patent Application Publication No. 2004-343735 (Document 2) in which a matching circuit 30a formed by a phase shifter is provided between the common terminal Ant and the second filter 20, and a matching circuit 30b formed by a phase shifter is provided between the common terminal Ant and the first filter 10. Fig. 4 shows yet another duplexer (third prior art) disclosed in Japanese Patent Application Publication No. 2004-343735 (Document 2) in which an inductor L30 for matching is provided between the common terminal Ant and ground. Japanese Patent Application Publication No. 10-313229 (Document 3) describes a technique (fourth prior art) of changing the design of interdigital transducers of surface acoustic wave resonators of the first filter 10 and the second filter 20 in addition to the third prior art. International Publication No. 2003/001668 (Document 4) discloses a further duplexer (fifth prior art) in which a capacitor is connected between one of the two filters and the common terminal in addition to the third prior art. Japanese Patent Application Publication No. 05-183380 (Document 5) discloses a filter in which an additional inductor is connected between a ladder type filter and ground (sixth prior art).

The first prior art can provide the miniaturized duplexer of low insertion loss because the matching circuit 30a is provided for only one of the filters. Particularly, the first prior art provides a considerably low insertion loss in a case where the transmit and receive bands have a frequency interval as small as 20 MHz. Such a case may be a North American 800MHz CDMA (in which the transmit band ranges from 824 to 849 MHz and the receive band ranges from 869 to 894 MHz) or 1.9GHz CDMA (in which the transmit band ranges from 1850 to 1910 MHz, the receive band ranges from 1930 to 1990 MHz). However, the first prior art does not have good insertion loss in a case where the transmit and receive bands have a frequency interval as large as 130 MHz such as W-CDMA (in which the transmit band ranges from 1920 to 1980 MHz and the receive band ranges from 2110 to 2170 MHz). The use of the two matching circuits 30a and 30b in the second prior art provides a considerably low insertion loss for a large frequency interval between the transmit band and the receive band. However, the two matching circuits 30a and 30b is disadvantageous to downsizing the duplexer.

The third prior art uses the matching-use inductor L30 connected to the common terminal Ant and realizes downsizing. However, it is difficult to significantly reduce the insertion loss of the first filter 10 and that of the second filter 20. This is because there is a difficulty in simultaneously realizing matching with the first filter 10 and that with the second filter 20. The fourth prior art is intended to overcome the above problem and change the design of interdigital transducers of the surface acoustic wave resonators of the first and second filters 10 and 20. However, this makes the design complicated.

When the sixth prior art is applied to the duplexer, the additional inductor and the matching circuit are housed in the identical package, which has a difficulty in downsizing. The downsizing of the duplexer needs closer arrangements of interconnections in the package. If the additional inductor is close to the matching circuit, a crosstalk occurs therebetween and degrades the out-of-band characteristics.

### SUMMARY OF THE INVENTION

The present invention has been made in view of the above circumstances and provides a duplexer having an improved insertion loss, an improved out-of-band characteristic and reduced dimensions.

According to an aspect of the present invention, there is provided a duplexer comprising: a first filter connected to a common terminal; a second filter connected to the common terminal; an additional inductor connected between at least one of the first and second filters and ground; a matching-use inductor connected between the common terminal and the ground; and a capacitor connected between the common terminal and at least one of the first and second filters.

### BRIEF DESCRIPTION OF THE DRAWINGS

Preferred embodiments of the present invention will be described in detail based on the following figures, wherein:
Fig. 1 is a block diagram of a duplexer;
Fig. 2 is a block diagram of a first conventional duplexer;

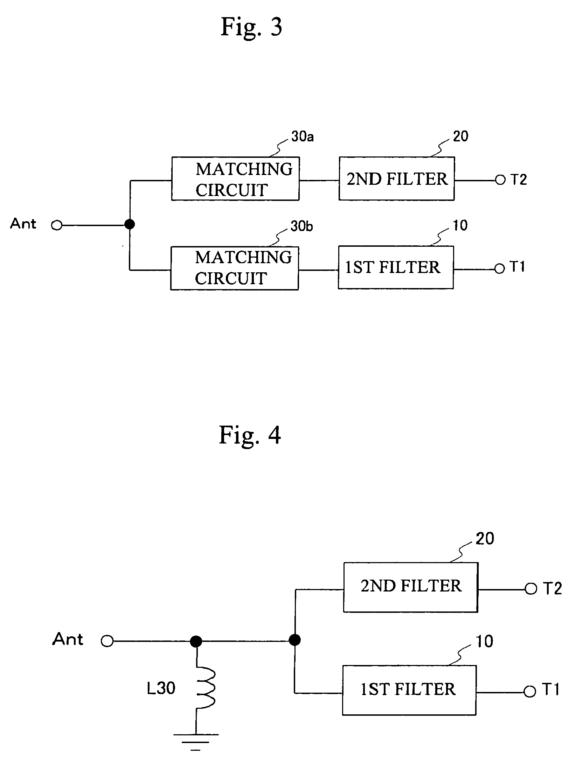

Fig. 3 is a block diagram of a second conventional duplexer;
Fig. 4 is a block diagram of a third conventional duplexer;
Fig. 5 is a block diagram of a duplexer in accordance with a first embodiment;
Fig. 6 is a circuit diagram of the duplexer of the first embodiment;
Fig. 7A is a plan view of an integrated passive device used in the first conventional duplexer;
Fig. 7B is a cross-sectional view of an MIM capacitor used in the integrated passive device;
Fig. 8 is a circuit diagram of a comparative example;
Fig. 9A is a graph of filter characteristics of the first embodiment and the comparative example;
Fig. 9B is an enlarged view of pass bands of the first embodiment and the comparative example;
Fig. 10A is a diagram showing an impedance observed by viewing a first filter from a common terminal;
Fig. 10B is a Smith chart of the first filter;
Fig. 11A is a diagram showing an impedance observed by viewing a second filter from the common terminal;
Fig. 11B is a Smith chart of the second filter;
Fig. 12 is a block diagram of a variation of the first embodiment;
Fig. 13 is a plan view of an integrated passive device used in the variation of the first embodiment;
Fig. 14A is a cross-sectional view of a duplexer in accordance with a second embodiment;
Fig. 14B is a plan view of a first layer of a package of the duplexer shown in Fig. 14A;
Fig. 14C is a plan view of a second layer of the package;
Fig. 14D is a plan view of a third layer of the package;
Fig. 14E is a plan view of a fourth layer of the package;
Fig. 14F is a view of a bottom surface of the fourth layer observed seeing through the fourth layer from an upper side thereof;
Fig. 15 is a circuit diagram of a duplexer in accordance with a third embodiment;
Fig. 16 is a plan view of a chip on which a first filter and a capacitor are formed in accordance with the third embodiment;
Fig. 17A is a graph of filter characteristics of the third embodiment and the comparative example;
Fig. 17B is an enlarged view of pass bands of the third embodiment and the comparative example;
Fig. 18 is a plan view of a chip on which a first filter of a variation of the third embodiment and a capacitor used therein are formed;
Fig. 19 is a circuit diagram of a duplexer in accordance with a fourth embodiment; and
Fig. 20 is a plan view of a chip on which a first filter of the duplexer of the fourth embodiment and a capacitor used therein are formed.

### DESCRIPTION OF THE PREFERRED EMBODIMENTS

The following embodiments of the present invention are duplexers for W-CDMA (having a transmit band of 1920 to 1980 MHz and a receive band of 2110 to 2170 MHz), in which the first filter 10 is the transmit filter and the second filter 20 is the receive filter.

### [First Embodiment]

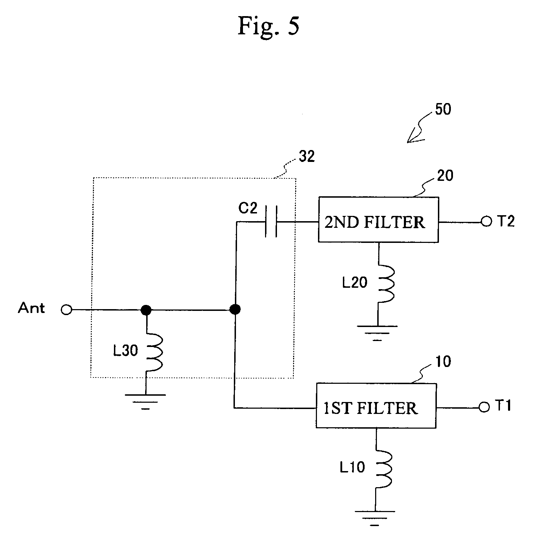

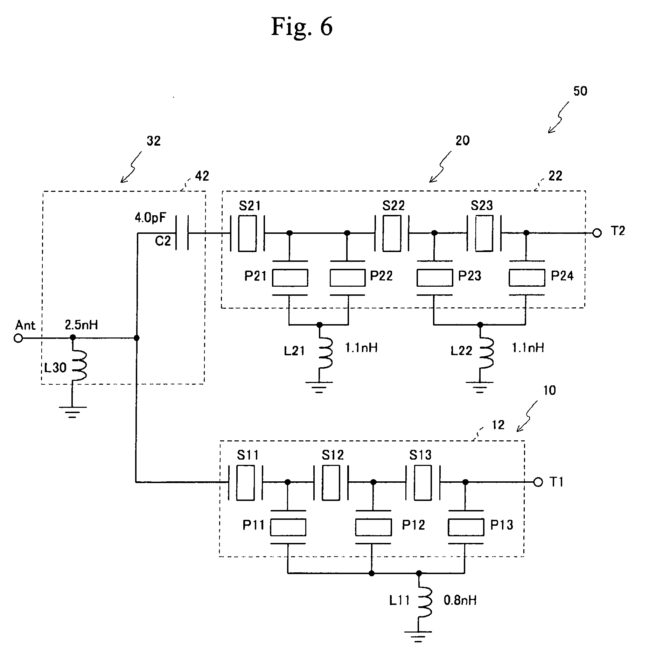

Fig. 5 is a diagram of a duplexer in accordance with a first embodiment, and Fig. 6 is a circuit diagram of the duplexer. Referring to Fig. 5, a duplexer 50 has the first filter 10 connected between the common terminal Ant and the first terminal T1 and the second filter connected between the common terminal Ant and the second terminal T2. Additional inductors L10 and L20 are connected between the ground and the first and second filters 10 and 20, respectively. The duplexer 50 has a matching circuit 32 composed of an inductor L30 connected between the common terminal Ant and the ground, and a capacitor C2 connected between the common terminal Ant and the second filter 20.

Referring to Fig. 6, the first filter 10 is a ladder type filter having series resonators S11 through S13 and parallel resonators P11 through P13, which resonators may be piezoelectric thin-film resonators, which may be called film bulk acoustic resonators. The series resonators S11 through S13 are connected in series between the common terminal Ant and the first terminal T1. The parallel resonator P11 is connected between the series resonators S11 and S12, and the parallel resonator P12 is connected between the series resonators S12 and S13. The parallel resonator P13 is connected between the series resonator S13 and the first terminal T1. An additional inductor L11 (equal to, for example, 0.8 nH) is connected between a common node of the parallel resonators P11 through P13 and the ground. The series resonators S11 through S13 and the parallel resonators P11 through P13 may be mounted on an identical substrate (chip 12).

The second filter 20 is a ladder type filter composed of series resonators S21 through S23 and parallel resonators P21 through P24, which may be piezoelectric thin-film resonators. The series resonators S21 through S23 are connected in series between the common terminal Ant and the second terminal T2. The parallel resonators P21 and P22 are connected in parallel between the series resonators S21 and S22. The parallel resonator P23 is connected between the series resonators S22 and S23, and the parallel resonator P24 is connected between the series resonator S23 and the terminal T2. An additional inductor L21 (equal to, for example, 1.1 nH) is connected between the ground and the common node for the parallel resonators P21 and P22. An additional inductor L22 (equal to, for example, 1.1 nH) is connected between the ground and the common node for the parallel resonators P23 and P24. The series resonators S21 through S23 and the parallel resonators P21 through P24 may be formed on an identical substrate (chip 22).

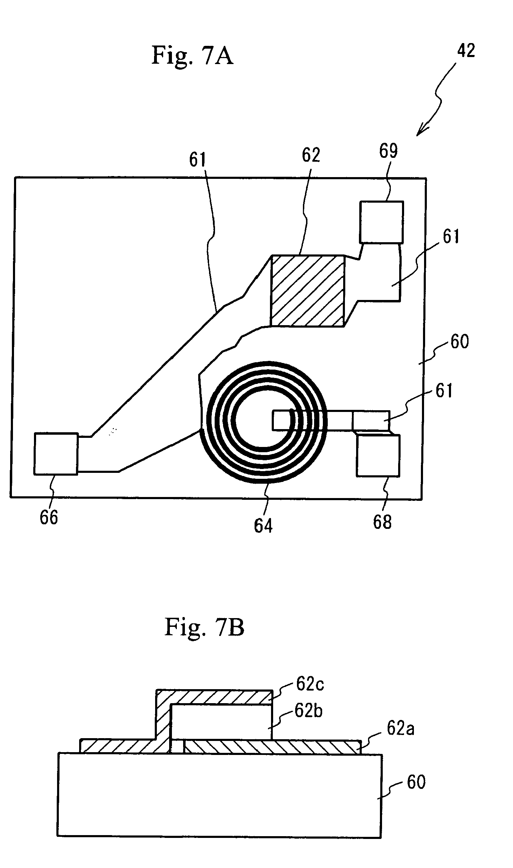

The matching-use inductor L30 in the matching circuit 32 has an inductance of, for example, 2.5 nH, and the capacitor C2 has a capacitance of, for example, 4.0 pF. The inductor L30 and the capacitor C2 are formed on a single chip as an integrated passive device IPD 42. Referring to Fig. 7A, the IPD 42 has an MIM capacitor 62 and an inductor 64 on a substrate 60, which may be a silicon substrate or a quartz substrate. The inductor 64 may be a spiral coil. Fig. 7B is a cross-sectional view of the MIM capacitor 62. The MIM capacitor 62 has the substrate 60 on which a lower electrode film 62a made of, for example, aluminum or copper, a dielectric film 62b that may be a silicon oxide film, and an upper electrode film 62c made of, aluminum or copper. The inductor 64 may be a line made of aluminum or copper. Pads 66, 68 and 69 are provided on the substrate 60. The pad 66 is connected to the common terminal Ant, and the pad 68 is connected to the ground. The pad 69 is connected to the second filter 20. The pads 66, 68 and 69, the MIM capacitor and the inductor 64 are connected by an line 61 of aluminum or copper.

The chips 12 and 22 and the IPD 42 are mounted on a laminate package having dimensions of 3 mm x 3 mm. The additional inductors L11, L21 and L22 are provided on the laminate package in the same manner as the inductor L30 for matching is provided within the laminate package in the second embodiment.

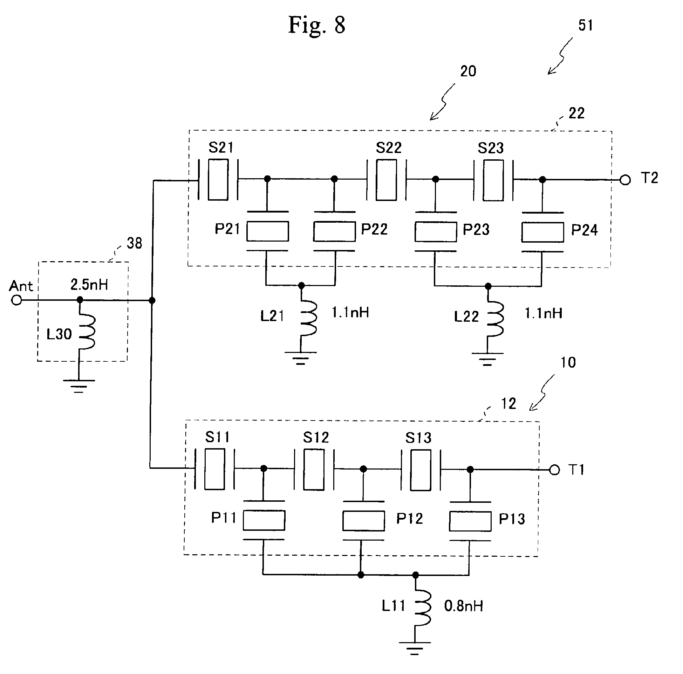

The inventors measured the filter characteristic of the duplexer 50 of the first embodiment and that of a duplexer 51 shown in Fig. 8 prepared as a comparative example. The comparative example of the duplexer 51 shown in Fig. 8 is configured by omitting the capacitor C2 from the matching circuit 32 of the duplexer 50 so that only the inductor L30 is provided between the common terminal Ant and ground as a matching circuit 38.

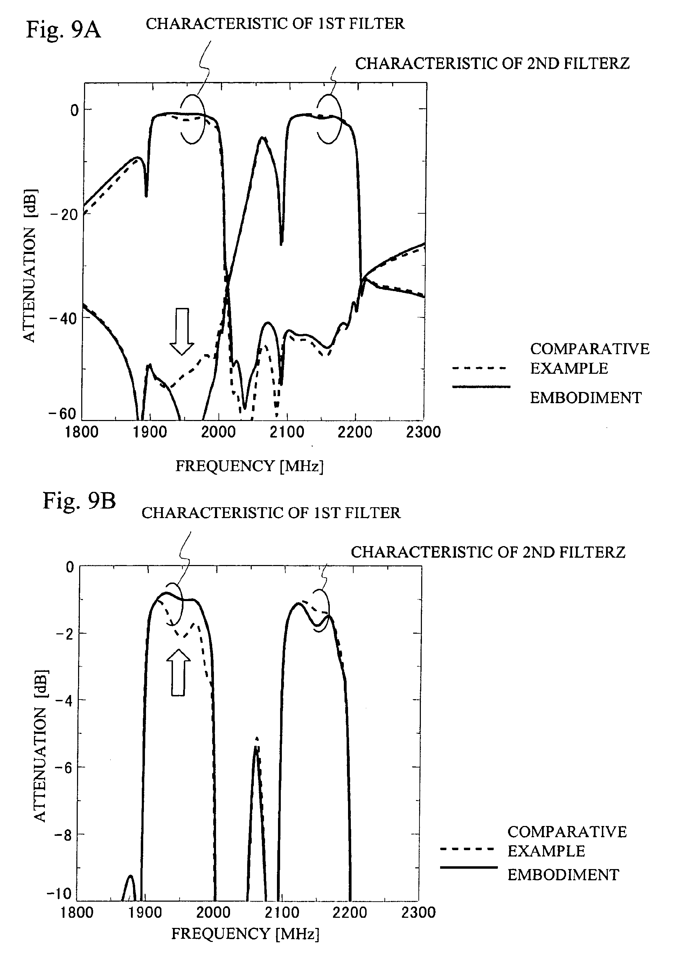

Fig. 9A is a graph of filter characteristics of the duplexers 50 and 51, and Fig. 9B is an enlarged view of the pass bands thereof. The pass bands of the first and second filters 10 and 20 are close to each other so that a part of the rising end of one of the pass bands overlaps with a part of the falling end of the other pass band. As indicated by an arrow in Fig. 9A, in accordance with the first embodiment, the second filter 20 has a large amount of attenuation in the pass band of the first filter 10, so that the duplexer has an improved out-of-band characteristic. As indicated by an arrow in Fig. 9B, the insertion loss of the first filter 10 in the pass band can be improved in accordance with the first embodiment. The improvements in the out-of-band characteristic and insertion loss result from the use of the matching circuit 32 that improves the matching conditions of both the first filter 10 and the second filter 20 viewed from the common terminal Ant.

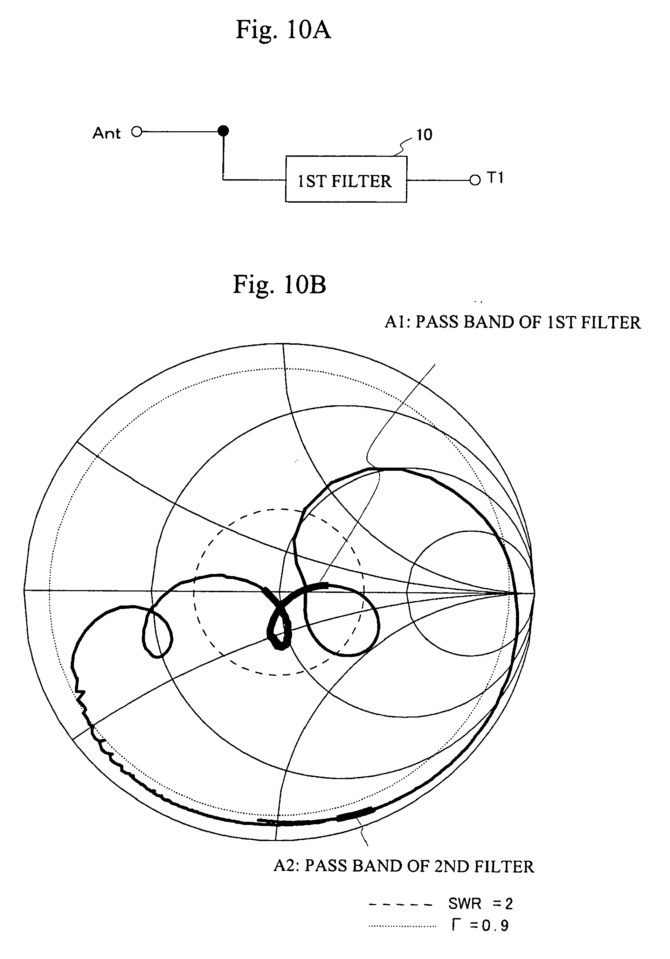

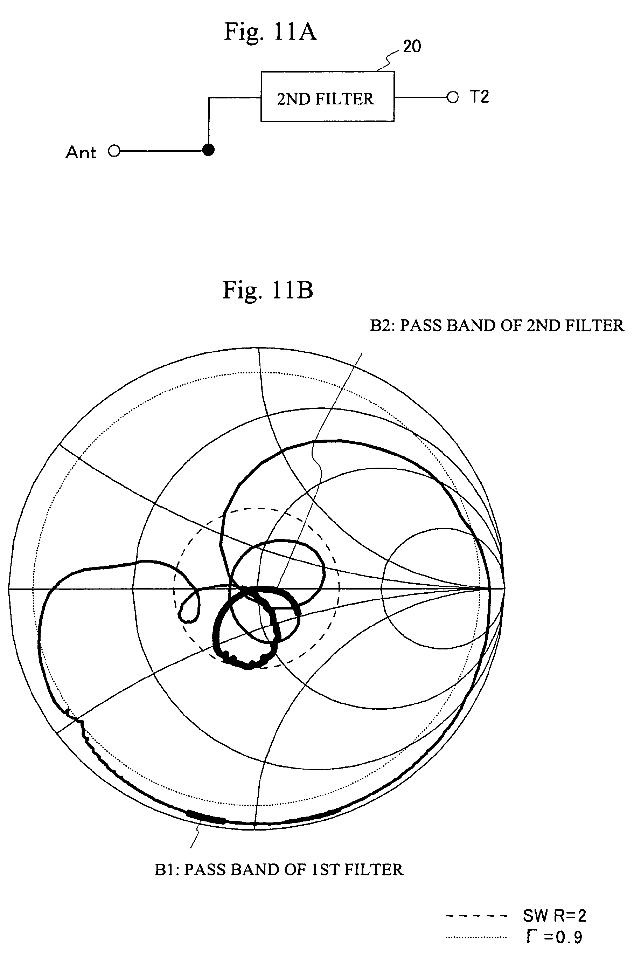

In contrast, the comparative example has a difficulty in realizing the matching with both the first filter 10 and the second filter 20 because of the following reasons. Fig. 10B is a Smith chart showing an impedance characteristic obtained by viewing the first filter 10 from the common terminal Ant in a case where the matching circuit and the second filter 20 shown in Fig. 10A are not connected, as shown in Fig. 10A. A thick solid line shown around the center of the chart indicates a pass band A1 of the first filter 10, and another thick solid line shown on a lower side of the chart indicates a pass band A2 of the filter 20. Fig. 11B is a Smith chart showing an impedance characteristic obtained by viewing the second filter 20 from the common terminal Ant in a case where the matching circuit and the first filter 10 shown in Fig. 10A are not connected, as shown in Fig. 11A. A thick solid line shown around the center of the chart indicates a pass band B2 of the second filter 20 and another thick solid line on a lower side of the chart indicates a pass band B1 of the first filter 10.

In the duplexer with the first and second filters 10 and 20 being connected, the impedance of the pass band of the first filter 10 is the synthesis of A1 and B1, and the impedance of the pass band of the second filter 20 is the synthesis of A2 and B2. The impedance A1 of the first filter 10 and the impedance B2 of the second filter 20 in the respective pass bands are located about the center of the Smith chart and are 50 Ω. In contrast, the impedance A2 of the first filter 10 in the pass band of the second filter 20 and the impedance B1 of the second filter in the pass band of the first filter 10 have different phases. Therefore, the comparative example having the matching-use inductor L30 common to the first and second filters 10 and 20 has a difficulty in matching both the pass band of the first filter 10 and the pass band of the second filter 20.

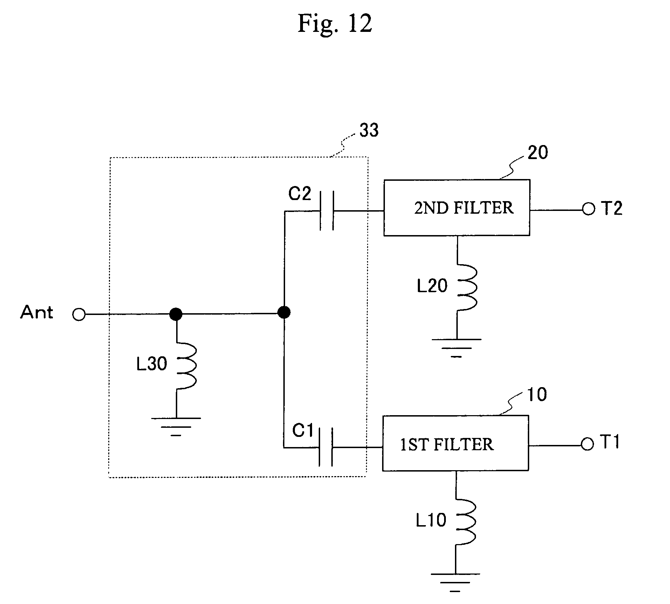

According to the first embodiment, the capacitor C2 is added to the second filter 20 in addition to the inductor L30 for matching. It is thus possible to separately and simultaneously make matching with the pass band of the first filter 10 and matching with the pass band of the second filter 20. The matching circuit 32 is made up of the inductor L30 and the capacitor C2, so that the duplexer 50 can be miniaturized. Fig. 12 shows a variation of the first embodiment. The variation has a matching circuit 33 having a capacitor C1 provided between the common terminal Ant and the first filter 10 in addition to the aforementioned capacitor C2. It is possible to meet the conditions for matching with the pass band of the first filter 10 and matching with the pass band of the second filter 20 by appropriately selecting the values of the capacitors C1 and C2. The capacitor C2 may be omitted from the second filter 20 but only the capacitor C1 may be added to the first filter 10.

As described above, the first embodiment employs the matching circuit 32 in such an arrangement that the additional inductors L11, L21 and L22 are used for improving the out-of-band characteristic. The matching circuit 32 improves the insertion loss in the pass bands even when the transmit and receive pass bands have a guard-band as large as 130 MHz. The matching circuit 32 is composed of the inductor L30 for matching and capacitors C1 and/or C2, and is structurally simple. Thus, the matching circuit 32 is suitable for downsizing. The simple structure of the matching circuit 32 makes it possible to suppress crosstalk between interconnections even when the additional inductors L11, L21 and L22 and the matching circuit 32 are integrally mounted on the same package and to improve the out-of-band characteristic. Particularly, when the first and second filters 10 and 20 are ladder-type filters, the attenuation poles may be formed in the opponent bands, so that the out-of-band characteristics can be further improved. The additional inductors L11, L21 and L22 may be added to at least one of the first filter 10 and the second filter 20. The filter with the additional inductors being added has improved out-of-band characteristics.

The additional inductors L11, L21 and L22 may be provided between every parallel resonator of at least one of the first and second filters 10 and 20 and the ground. It is thus possible to increase attenuation amounts provided by the attenuation poles formed in the opponent bands and to further improve the out-of-band characteristics.

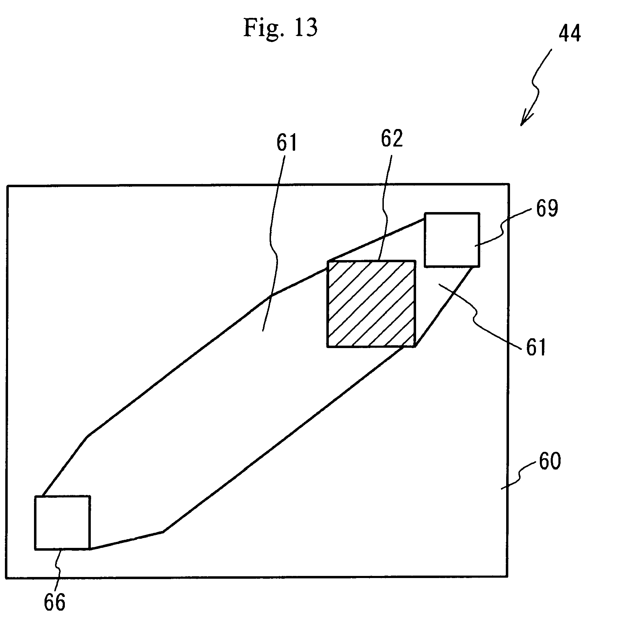

In the first embodiment, the capacitor C2 and the matching-use inductor L30 are integrally formed on the substrate 60 so as to form the IPD 42. A second variation as shown in Fig. 13 may be used. The second variation does not include the matching-use inductor L30 in the IPD but forms the capacitor C2 on the substrate 60, so that an IPD 44 is formed. Fig. 13 shows that the MIM capacitor 62, pads 66 and 69 and an interconnection 61 are formed on the substrate 60 as shown in Fig. 7A. In the second variation, the matching-use inductor L30 is formed within the laminate package like the second embodiment. The capacitor C1 or C2 may be formed on a substrate separate from the substrate on which the first filter 10 and the second filter 20 are formed. Some or all of the additional inductors L11, L21 and L22 may be formed on the substrate 60. At least one of the additional inductors L11, L21 and L22 and the matching-use inductor L30 may be formed on the substrate on which the capacitor C1 or C2 is formed. The integrated passive device IPD thus formed makes it possible to reduce the mount area and miniaturize the duplexer.

### [Second Embodiment]

A second embodiment has an arrangement in which a capacitor is formed by an IPD and a matching-use inductor is formed within the laminate package. As shown in Fig. 12, the second embodiment has the matching circuit 33 has the capacitor C1 provided between the common terminal Ant and the first filter 10 and the capacitor C2 provided between the common terminal Ant and the second filter 20 in addition to the matching-use inductor L30 provided between the common terminal Ant and the ground. The capacitors C1 and C2 are formed as an IPD as shown in Fig. 13.

Figs. 14A through 14F show a laminate package 100 for the duplexer of the second embodiment. More specifically, Fig. 14A is a cross-sectional view of the laminate package 100, which has a size of 3 mm x 3 mm, and includes ceramic layers 108. A first layer 101 provides a die attach surface 109. The package 100 has a second layer 102, a third layer 103 and a fourth layer 104 in addition to the first layer 101. The fourth layer 104 has a bottom surface 105 on which foot patterns are formed. Signals are input and output via the foot patterns. A power supply is applied to the duplexer via the foot patterns. The layers have vias 106 filled with a conductor, and conductive patterns 107. The chip and the foot patterns are electrically connected via the vias 106 and the conductive patterns 107. The structure of the additional inductors may be the same as the matching-use inductor L30.

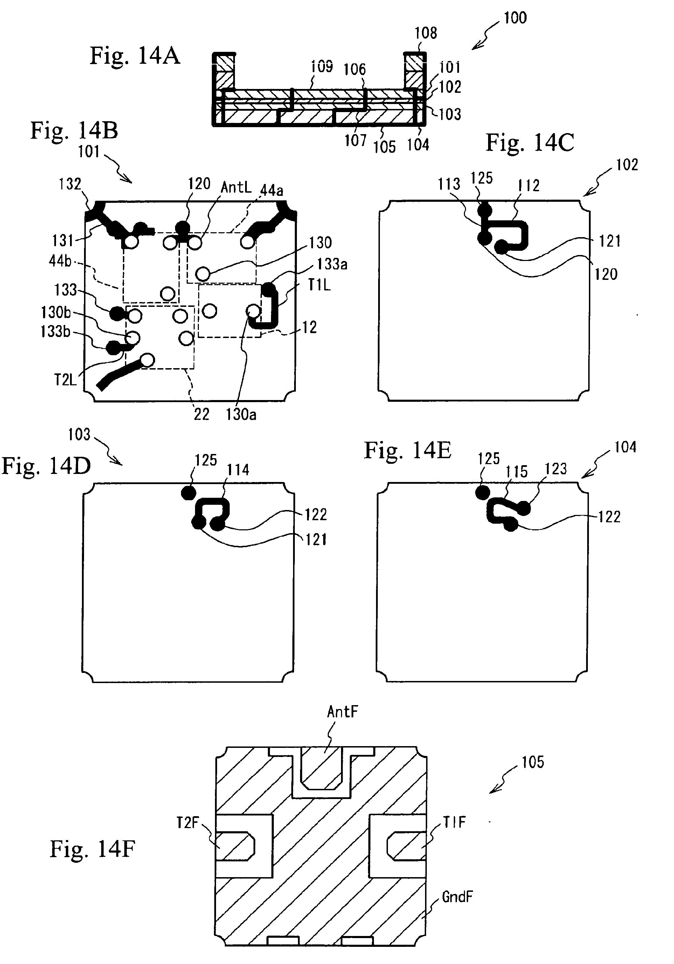

Fig. 14B shows the upper surface (die attach surface) of the first layer 101. Broken lines show the positions of the chip 12, chip 22, IPD 44a and IPD 44b. The first filter 10 is formed on the chip 12, and the second filter 20 is formed on the chip 22. The capacitor C1 is formed in the IPD 44a, and the capacitor C2 is formed in the IPD 44b. The chips are mounted on the die attach surface by bumps (not shown). Interconnection patterns 131 made of a conductor, bump pads 130, and vias 133 full of a conductor are formed in or on the first layer 101. The first terminal T1 is connected to a line pattern T1L via a bump pad 130a, and the second terminal T2 is connected to a line pattern T2L via a bump pad 130b. Further, the first terminal T1 is connected to a first terminal foot pattern T1F formed on the bottom surface 105 of the fourth layer 104 via a via 133a. The second terminal T2 is connected to a second terminal foot pattern T2F formed on the bottom surface 105 of the fourth layer 104 via a via 133b. The ground terminals are connected to a ground foot pattern GndF formed on the bottom surface 105 via vias 133 or side castellations 132 close to the terminals. The common terminals Ant of the IPDs 44a and 44b are connected to a line pattern AntL and a via 120.

Fig. 14C shows the upper surface of the second layer 102. Figs. 14C and 14D do not show the vias 133, 133a and 133b. The via 120 of the first layer 101 is connected to the via 120 of the second layer 102, which is connected to a via 125 through a line pattern 113. The via 125 is connected to a common foot pattern AntF formed on the bottom surface 105 of the fourth layer 104. The via 120 is connected to the via 121 through a line pattern 112. The via 121 is connected to the third layer 103.

Fig. 14D shows the upper surface of the third layer 103. The via 121 is connected to the via 122 through a line pattern 114. The via 122 is connected to the fourth layer 104. Fig. 14E shows the upper surface of the fourth layer 104. The via 122 is connected to a via 123 through a line pattern 115. The via 123 is connected to the bottom surface 105 of the fourth layer 104.

Fig. 14F is a view of the bottom surface 105 of the fourth layer observed seeing through the fourth layer 104 from the upper side thereof. On the bottom surface 105, provided are the common foot pattern AntF, the first terminal foot pattern T1F, the second terminal foot pattern T2F and the ground foot pattern GndF. The via 123 is connected to the ground foot pattern GndF. This forms the matching-use inductor connected between the common terminal and the ground, the matching-use inductor being made up of the line patterns 112, 114 and 115 and the vias 121, 122 and 123.

As described above, at least one of the additional inductors and the matching-use inductor is provided on the package on which the chips 12 and 14 are mounted. The inductor thus formed includes the ceramic and conductive material of the package, and has a great Q. Thus, the duplexer of the present embodiment has reduced insertion loss.

The package 100 has the laminate structure, which makes it possible to easily form at least one of the additional inductors and the matching-use inductor by line patterns formed on the layers 102 to 104 of the package 100.

### [Third Embodiment]

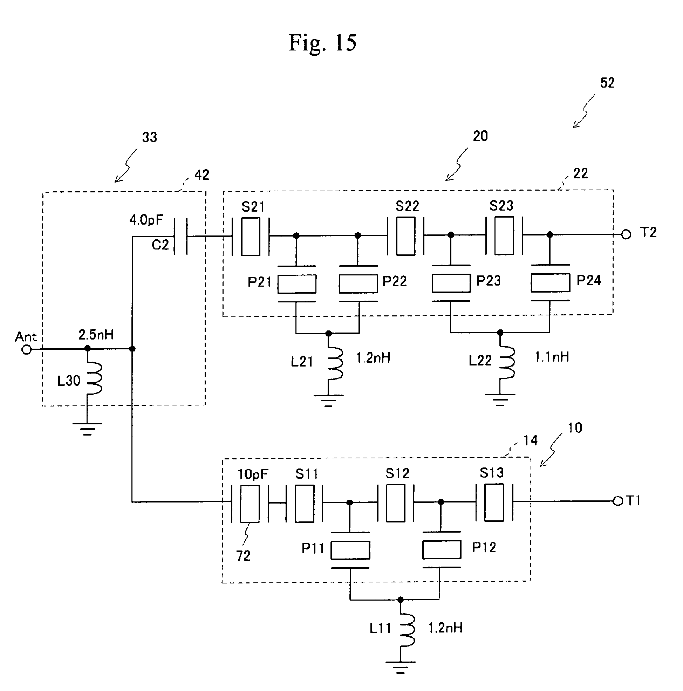

A third embodiment employs a piezoelectric thin film resonator for the capacitor of the matching circuit 33. Fig. 15 is a circuit diagram of a duplexer 52 in accordance with the third embodiment. A piezoelectric thin film resonator 72 functioning as a capacitor of the matching circuit 33 is formed on the chip on which the first filter 10 is formed. The first filter 10 is not provided with the parallel resonator P13. The additional inductors L11, L21 and L22 have inductance values of, for example, 1.2 nH, 1.2 nH and 1.1 nH, respectively. The other structure of the first embodiment is the same as the structure shown in Fig. 6, and the same reference numerals are assigned thereto.

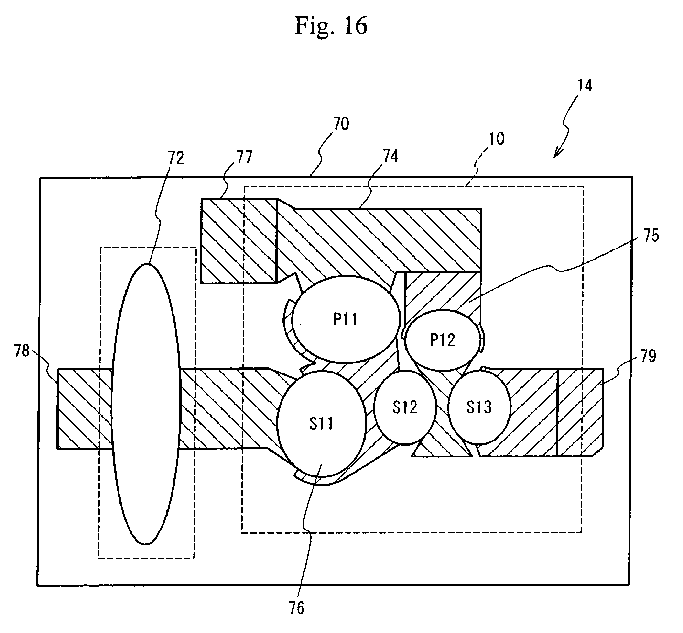

Fig. 16 is a plan view of the chip 14 used in the third embodiment. A lower electrode film 75, an aluminum nitride piezoelectric film (not shown), and an upper electrode film 74 are formed on a substrate 70, which may be a silicon substrate. A membrane region 76 is formed so that the lower electrode film 75, the piezoelectric film and the upper electrode film 74 overlap with each other. Symbols P11, P12, S11, S12 and S13 respectively denote membrane regions of the resonators. The membrane regions are mutually connected through the lower electrode film 75 or the upper electrode film 74. A pad 79 connected to the first terminal T1 is formed by the lower electrode film., and a pad 77 connected to the ground is formed by the upper electrode film. A piezoelectric thin film resonator 72 serving as the capacitor C1 is provided between the series resonator S11 and a pad 78 connected to the common terminal Ant. Preferably, the resonant frequency of the piezoelectric thin film resonator 72 is located out of the pass band of the first filter 10.

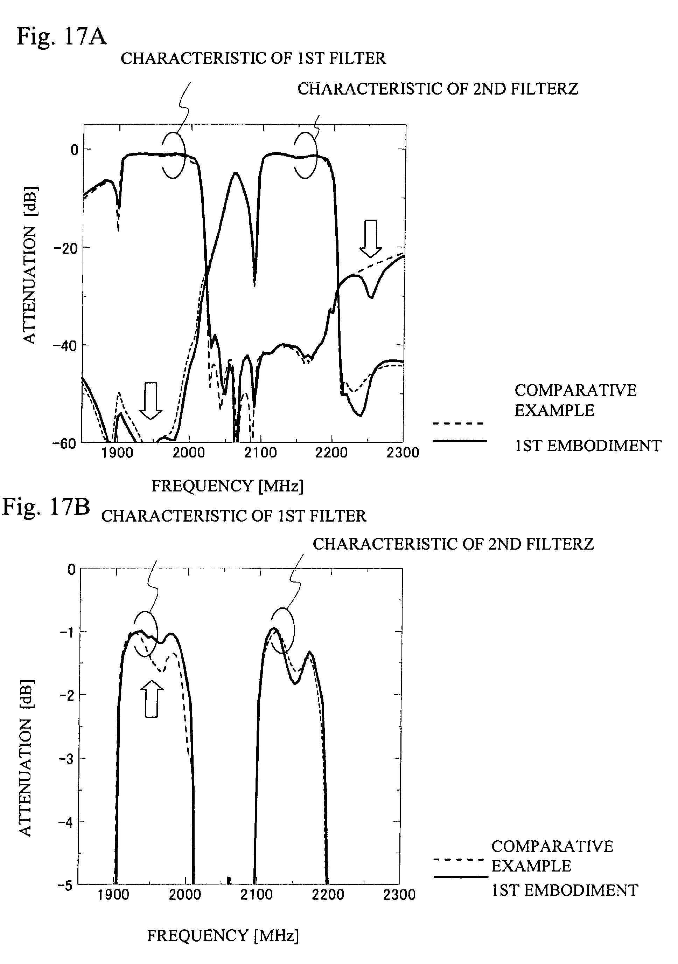

The filter characteristics of the duplexer 53 of the third embodiment and the duplexer 51 of the aforementioned comparative example were measured. Fig. 17A shows the filter characteristics of the duplexers 53 and 51, and Fig. 17B is an enlarged view of the pass bands thereof. As shown by arrows in Figs. 17A and 17B, the second filter 20 has a large attenuation in the pass band of the first filter 10 (the opponent band), so that the out-of-band characteristic can be improved as in the case of the first embodiment. The insertion loss in the pass band of the first filter 10 is reduced. Further, as shown by the arrow on the right-hand side of Fig. 17A, the first filter 10 has a large attenuation in the stop band at the high-frequency side of the second filter 20. This is because the antiresonance point of the piezoelectric thin film resonator 72 exists in the stop band of the first filter 10.

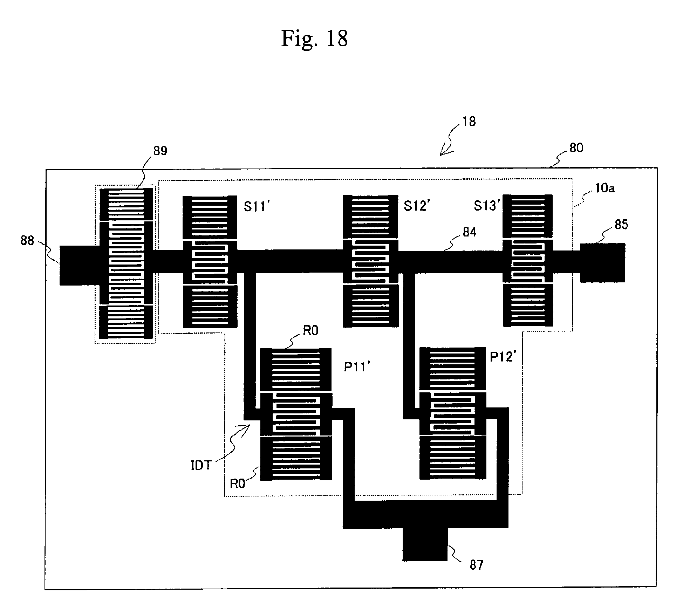

Fig. 18 shows a variation of the third embodiment, which has the capacitor C1 connected to the first filter 10 formed by a surface acoustic wave resonator 89 formed on a piezoelectric substrate 80. The first filter 10 is formed by surface acoustic wave resonators formed on the piezoelectric substrate 80. The solid portions in Fig. 18 are patterns of aluminum or the line formed on the piezoelectric substrate 80. A first filter 10a is formed by surface acoustic wave resonators S11', S12', S12', P11' and P12'. Each of the resonators is made up of an interdigital transducer IDT and resonators arranged at both sides of the IDT in a direction in which a SAW is propagated. Pads 85, 87 and 88 are formed on the piezoelectric substrate 80. The pad 85 is connected to the first terminal T1, and the pad 87 is connected to the ground, the pad 88 being connected to the common terminal Ant. The surface acoustic wave resonator 89 serving as the capacitor C1 is provided between the pad 88 and the resonator S11'. The surface acoustic wave resonator 89 has an electrode finger pitch that is different from that of each of the resonators forming the ladder-type filter. This is intended to place the resonant frequency of the surface acoustic wave resonator 89 outside of the pass band of the ladder-type filter. The resonator 89 may be modified so that the resonator 89 does not have the reflectors but is formed by the IDT only.

### [Fourth Embodiment]

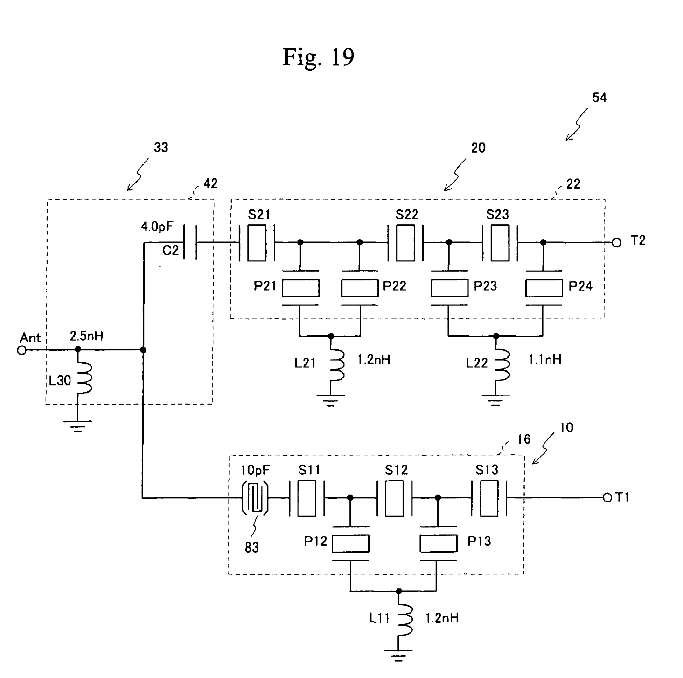

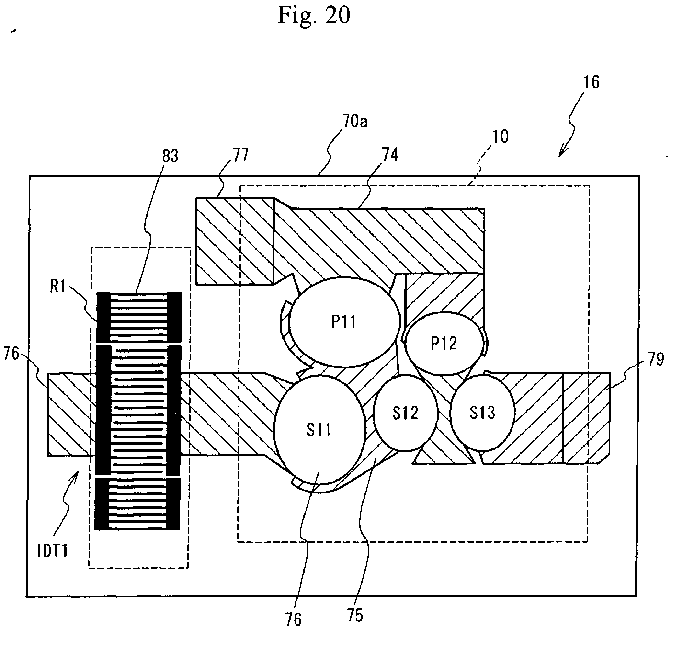

A fourth embodiment has the first filter 10 formed by a ladder-type filter composed of piezoelectric thin film resonators, and the surface acoustic wave resonator 83 that forms the capacitor C1 of the matching circuit 33. Fig. 19 is a circuit diagram of a duplexer 54 in accordance with the fourth embodiment. In Fig. 19, parts that are the same as those shown in Fig.15 are given the same reference numerals, and a description thereof will be omitted. The surface acoustic wave resonator 83 serving as the capacitor C1 of the matching circuit 33 is formed on the chip 16 on which the first filter 10 is formed. Fig. 20 is a plan view of the chip 16 on which the first filter 10 and the surface acoustic wave resonator 83 are formed. The first filter 10 formed by the piezoelectric thin film resonators and the surface acoustic wave resonator 83 are formed on a piezoelectric substrate 70a. The structure of the first filter 10 is the same as shown in Fig. 16. The surface acoustic wave resonator 83 is composed of a surface acoustic wave interdigital transducer IDT1 and reflectors R1 provided at both sides of the IDT1 in the SAW propagation direction.

Like the third and fourth embodiments, the series and parallel resonators used for forming the first filter 10 and the second filter 20 may be surface acoustic wave resonators or piezoelectric thin film resonators. Further, at least one of the capacitors C1 and C2 used to form the matching circuit may be a surface acoustic wave interdigital transducer or a piezoelectric thin film resonator formed on the chip on which the series and parallel resonators are formed.

Preferably, the resonant frequencies of the surface acoustic wave IDT or piezoelectric thin film resonator are located out of the pass band of the filter formed by the series and parallel resonators. This arrangement further increases the attenuation outside of the pass band.

Preferably, the matching circuit has a capacitor implemented by the surface acoustic wave interdigital transducer formed on the chip on which the series and parallel resonators re formed. The resonant frequency of the surface acoustic wave interdigital transducer may be easily adjusted by changing the electrode finger pitch. In contrast, the resonant frequency of the piezoelectric thin film resonator needs a complicated process, which may change the thickness of the piezoelectric film.

Like the variation of the third embodiment, the fabrication process may be simplified by the structure of the duplexer in which the surface acoustic wave resonators are used as the series and parallel resonators of the first and second filters 10 and 20, and the surface acoustic wave interdigital transducer formed on the same substrate or chip as the series and parallel resonators is used to form at least one of the capacitors C1 and C2.

Like the fourth embodiment, the series and parallel resonators of the first and second filters 10 and 20 may be piezoelectric thin film resonators, and at least one of the capacitors C1 and C2 may be a surface acoustic wave interdigital transducer formed on the same substrate as the parallel and series resonators. The use of the ladder-type filter of the piezoelectric thin film resonators improves the filter characteristic. The use of the surface acoustic wave IDT for the capacitor makes it easy to adjust the resonant frequency.

The first through fourth embodiments are duplexers having a transmit band of 1920 to 1980 MHz and a receive band of 2110 to 2170 MHz. However, the present invention is not limited to the above frequency ranges.

The present invention is not limited to the specifically described embodiments, but other embodiments, variations and modifications may be made without departing from the scope of the present invention.

The present invention is based on Japanese Patent Application No. 2005-244643 filed on August 25, 2005, and the entire disclosure of which is hereby incorporated by reference.

## Claims

1. A duplexer comprising:
a first filter connected to a common terminal;
a second filter connected to the common terminal;
an additional inductor connected between at least one of the first and second filters and ground;
a matching-use inductor connected between the common terminal and the ground; and
a capacitor connected between the common terminal and at least one of the first and second filters.

2. The duplexer as claimed in claim 1,
wherein:
said at least one of the first and second filters to which the additional inductor is connected is a ladder-type filter composed of parallel and series resonators; and
the additional inductor is connected between at least one of the parallel resonators and the ground.

3. The duplexer as claimed in claim 1,
wherein:
said at least one of the first and second filters to which the additional inductor is connected is a ladder-type filter composed of parallel and series resonators; and
the additional inductor is connected between all the parallel resonators and the ground.

4. The duplexer as claimed in claim 1, wherein the first and second filters are formed on a substrate, and the capacitor is formed on another substrate.

5. The duplexer as claimed in claim 1, wherein at least one of the additional inductor and the matching-use inductor is formed on a substrate on which the capacitor is formed.

6. The duplexer as claimed in claim 1, wherein the parallel and series resonators are piezoelectric thin film resonators or surface acoustic wave resonators.

7. The duplexer as claimed in claim 1,
wherein:
the parallel and series resonators are piezoelectric thin film resonators or surface acoustic wave resonators; and
the capacitor is a surface acoustic wave interdigital transducer or a piezoelectric thin film resonator formed on a substrate on which the parallel and series resonators are formed.

8. The duplexer as claimed in claim 1,
wherein:
the parallel and series resonators are surface acoustic wave resonators; and
the capacitor is a surface acoustic wave interdigital transducer formed on a substrate on which the parallel and series resonators are formed.

9. The duplexer as claimed in claim 1,
wherein:
the parallel and series resonators are piezoelectric thin film resonators; and
the capacitor is a surface acoustic wave interdigital transducer formed on a substrate on which the parallel and series resonators are formed.

10. The duplexer as claimed in claim 1,
wherein:
the capacitor is formed by a resonator that is either a piezoelectric thin film resonator or a piezoelectric thin film resonator; and
the resonator of the capacitor has a resonant frequency located out of a pass band of a ladder-type filter that is one of the first and second filers.

11. The duplexer as claimed in claim 1, wherein at least one of the additional inductor and the matching-use inductor is formed on a package on which a chip of the first filter and another chip of the second filter are mounted.

12. The duplexer as claimed in claim 1, wherein the package has a laminate package, and at least one of the additional inductor and the matching-use inductor is a line pattern formed on a layer included in the laminate package.
